# EUROPEAN PATENT APPLICATION

(11) **EP 2 254 157 A1**
(43) Date of publication of application: **24.11.2010**
(21) Application number: 08714962.1
(22) Date of filing: 14.03.2008
(51) Int. Cl.: H01L 31/052

(54) **SOLAR CELL DEVICE WITH HIGH HEAT DISSIPATION EFFICIENCY**

(71) Applicant: NeoBulb Technologies, Inc., Bandar Seri Begawan (BN)
(72) Inventor: LIN, Chung-Zen, Taiwan (CN)
(74) Representative: Goddar, Heinz J.
(86) International application number: PCT/CN2008/000509
(87) International publication number: WO 2009/111908

(57) **Abstract**

The invention provides a solar cell apparatus with high heat-dissipating efficiency. The solar cell apparatus includes a heat-conducting device, a heat-dissipating device, and an energy-converting device. The heat-conducting device includes a flat portion and a contact portion. The heat-dissipating device contacts the contact portion and includes a plurality of fins. The energy-converting device is disposed on the flat portion and includes a semiconductor structure for converting light into electricity. In the operation of converting energy, heat absorbed by the semiconductor structure could be conducted through the flat portion to the heat-conducting device and the heat-dissipating device and then be dissipated from the fins. Thereby, it is avoided for the semiconductor structure to be over heated to influence the energy conversion efficiency.

## Description

### BACKGROUND OF THE INVENTION

### 1. Field of the invention

The present invention relates to a solar cell converting apparatus, and more particularly, relates to a solar cell converting apparatus with a heat-dissipating structure.

### 2. Description of the prior art

With the depletion of petroleum, the need for alternative energy becomes important. In consideration of ecosystem impact, solar energy, wind power, and water power become major topics of development. Therein the solar energy is the most plentiful energy and energy radiated by the surface of the sun is about 3.8×10²³ kW. Though the earth surface is 150 million kilometers away from the sun, the amount of the solar energy reaching the earth surface is up to 1.8×1014 kW approximately that is ten thousand times larger than that humankind uses. If we could use the energy efficiently, it could solve the problems of not only depleting energy but also environment protection.

However, in a process of transducing photo energy into electricity, not all incident light could be absorbed by a solar cell for being converted into a current completely. A half of energy of photons is too low (lower than a band gap of a semiconductor) to output a current. Except some energy of the absorbed photons for generating electron-hole pairs, about a half of energy of the absorbed photos is converted into thermal energy which is then dissipated. Thus, the highest energy conversion efficiency of single solar cell is about 20∼30% and over a half of the solar energy is converted into thermal energy that affects the solar cell (raising working temperature of the solar cell). Too high working temperature will lead to lowering photoelectric conversion efficiency. With such the vicious circle, more and more solar energy will be dissipated by the form of thermal energy and the photoelectric conversion efficiency of the solar cell will decrease thereby.

Additionally, a solar cellar module with a larger area is often used for getting enough electrical energy. It also means there is more thermal energy to be generated and it is hard to dissipate the thermal energy. The above mentioned vicious circle will be worse. In the view of photoelectric conversion efficiency, the total conversion efficiency of such solar cell with a larger area will decrease thereby, so that the solar cell is seldom applied to the high power application. Additionally, the traditional solar cell module is usually fixed so that the magnitude of the absorbed solar energy changes with the radiation direction of the solar energy. In other words, the energy conversion power varies with time; that is, the solar energy could not be used sufficiently.

Based on the above mentioned reasons, the traditional solar cell could not raise the energy conversion efficiency and the energy conversion power. Therefore, it is necessary to provide a solar cell converting apparatus with an efficient heat-dissipating structure to solve the above mentioned problems.

### SUMMARY OF THE INVENTION

A scope of the present invention is to provide a solar cell apparatus which has a heat-dissipating structure with high heat-dissipating efficiency.

The solar cell apparatus of the invention includes a heat-conducting device, a heat-dissipating device, and an energy-converting device. The heat-conducting device includes a flat portion and a contact portion. The heat-dissipating device contacts the contact portion of the heat-conducting device and includes a plurality of fins. The energy-converting device is disposed on the flat portion of the heat-conducting device and includes a semiconductor structure for converting light into electricity. Therein, the semiconductor structure is a silicon-based semiconductor solar cell, a compound semiconductor solar cell, an organic semiconductor solar cell or other semiconductor structures capable of converting light into electricity. The heat-conducting device includes a heat pipe, a heat column or other materials with high heat-conducting efficiency. Additionally, when the heat-conducting device includes a heat pipe or a heat column, the flat portion of the heat-conducting device could be at an end of the heat pipe or the heat column.

Because over a half of solar energy is absorbed by the semiconductor structure in the form of heat, by the disposition of the invention, heat generated in a process of converting energy could be conducted to the heat-conducting device through the flat portion of the heat-conducting device where the energy-converting device contacts. The heat-conducting device transfers the conducted heat to the contact portion of the heat-conducting device by itself heat transfer mechanism. For example, a liquid in a heat pipe vaporizes into a gas by absorbing vaporization heat. The gas then flows to some cooler place by the way of convention. In other words, the gas contacts a cooler wall, the gas releases the absorbed vaporization heat by heat exchange to condense into the liquid, and it repeats the cycle. The temperature of the wall contacting the gas increases due to getting the vaporization heat. Therefore, the contact portion of the heat-conducting device of the invention could be at the wall which stores the heat carried by the gas. The heat conducted to the contact portion is conducted again to the heat-dissipating device contacting the contact portion. Finally, the heat could be dissipated from the fins of the heat-dissipating device, and the purpose of dissipating heat is then achieved.

In order to improve the utilization efficiency of solar energy, the solar cell apparatus of the invention further includes a light-converging device disposed near the energy-converting device for converging the light onto the semiconductor structure. The simplest way to converge the light is to use a cup-like reflection curve surface. Therefore, the light-converging device could include a cup-like reflection surface for reflecting and converging the light to irradiate onto the semiconductor structure. Additionally, it may be hard to converge all the light onto the semiconductor structure once due to the limitation of physical disposition. Therefore, the light-converging device of the invention could further include a reflection plane or a reflection curve surface for reflecting the light reflected by the cup-like reflection surface onto the semiconductor structure. The reflection plane could change the convergence direction of the light. The reflection curve surface not only has the functions that the reflection plane has but also could converge the light reflected by the cup-like reflection surface again. Thus, the light-converging device of the invention could make the semiconductor structure obtain more solar energy than a traditional solar cell and provides multi-reflection even multi-convergence effect by use of the reflection plane or the reflection curve surface to break through the limitation of the geometrical disposition of the light-converging device.

Additionally, in order to overcome the difficulty of the physical disposition of each device due to the reflection of the light by the cup-like reflection surface, a positive lens could be used for shortening the focus distance of the cup-like reflection surface. Therefore, the light-converging device of the invention includes a positive lens for converging the light reflected by the cup-like reflection surface onto the semiconductor structure. By doing so, the light-converging device of the invention could also overcome the above-mentioned difficulty of the physical disposition without the second reflection.

Additionally, the light-converging device of the invention could include a positive lens which replaces the cup-like reflection surface for converging the light onto the semiconductor structure. Of course, the above-mentioned light-converging device with the cup-like reflection surface could also include a positive lens disposed outsides of the cup-like reflection surface. That is, before the light is reflected by the cup-like reflection surface, the light has been converged by the positive lens and is then reflected by the cup-like reflection surface. Thus the cup-like reflection surface could reflect more rays of light and the amount of the solar energy irradiating onto the semiconductor structure will increase. Because the solar cell apparatus of the invention overcomes the problems of dissipating heat, light with high energy will not be a thermal burden to the semiconductor structure of the energy-converting device but raise the energy conversion power.

In an embodiment, the energy-converting device of the solar cell apparatus of the invention includes a substrate and a base. The substrate includes a first recess and a second recess communicating with the first recess. The base is disposed on the second recess and includes a surface toward the first recess. The semiconductor structure is disposed on the surface, and the base contacts the flat portion. Therein, an opening profile of the first recess is smaller than an opening profile of the second recess, so that the second recess has a top portion. The surface of the base contacts the top portion so that the base could be disposed on the second recess more firmly. Additionally, the semiconductor structure could be wire bonded with the base and the base is electrically connected to the substrate through the top portion of the second recess, so that the semiconductor structure and the substrate are electrically connected. Thus, the semiconductor structure could be electrically connected to and packed with the base without wire bonding with the substrate. In other word, the package for the semiconductor structure could be performed in advanced. It is helpful for simplifying a packing environment and raising the stability of packing and the yield rate. Additionally, the base is electrically connected to the top portion of the second recess by direct contact, which could improve the stability of electrical connection and prevent from instability resulting from wire bonding or packing.

Additionally, in the embodiment, the heat-conducting device includes a supporting portion and the substrate is mounted on the supporting portion firmly. The substrate is a silicon-based substrate, a ceramic substrate, a printed circuit board or a metallic substrate; the base is a silicon base, a ceramic base, a printed circuit board or a metallic base. Moreover, the semiconductor structure could be formed on the base directly by the technology of integrating process. It enhances the connection strength of the semiconductor structure; that is, the contact relation between the semiconductor structure and the base is improved to raise the heat-conducting efficiency of the semiconductor structure and the base, so that the heat generated in operation of the semiconductor structure could be dissipated by the heat-dissipating device more efficiently.

Another scope of the invention is to provide a solar cell apparatus with a plurality of energy-converting devices for raising energy conversion power

In this scope, the solar cell apparatus of the invention includes a plurality of heat-conducting devices, a plurality of heat-dissipating devices, a plurality of energy-converting devices, and a supporting member. Each of the heat-conducting devices includes a flat portion and a contact portion. Each of the heat-dissipating devices contacts the contact portion of one of the heat-conducting devices correspondingly and includes a plurality of fins. Each of the energy-converting devices is disposed on the flat portion of one of the heat-conducting devices correspondingly and includes a semiconductor structure for converting light into electricity. The supporting member connects the heat-conducting devices or the heat-dissipating devices.

For the single heat-conducting device, the single heat-dissipating device, and the single energy-converting device, the operation mechanism and the connection relations thereof are similar to those of the above-mentioned solar cell apparatus, so they will no longer be explained here. For example, in the scope, the solar cell apparatus could further includes a plurality of light-converging devices and each of the light-converging devices is correspondingly disposed near one of the energy-converting devices for converging the light onto the semiconductor structure of the corresponding energy-converting device. The light-converging device includes a cup-like reflection surface for reflecting and converging the light to irradiate onto the semiconductor structure. The light-converging device could further include a reflection plane or a reflection curve surface for reflecting the light reflected by the cup-like reflection surface onto the semiconductor structure.

In this scope, the solar cell apparatus of the invention further includes a light intensity-sensing device and a control circuit. Therein the light-converging device thereon defines a light convergence direction. The light intensity-sensing device senses a light intensity and the control circuit rotates the light-converging device for adjusting the light convergence direction according to the light intensity. The light intensity-sensing device could sense a radiation direction of the sunlight; for example, there are three light sensing chips with different directions to evaluate the radiation direction of the sunlight. Therefore the light intensity could be a direction parameter and it could include an intensity value further. The control circuit adjusts the light-converging device according to the light intensity, so that the light convergence direction could be substantially parallel to the radiation direction of the sunlight.

In an embodiment, the light intensity-sensing device includes a rotating device and the control circuit controls the rotating device to rotate the light intensity-sensing device with two degrees of freedom. The two degrees of freedom could be an angle of revolution and an angle of elevation. Thus, the light intensity-sensing device could include only one light-sensing chip and the control circuit controls the rotating device to rotate the light intensity-sensing device for obtaining light intensity with different directions, so as to evaluate or confirm the radiation direction of the sunlight. Then it could adjust the light-converging device according to the radiation direction for adjusting the light convergence direction substantially parallel to the radiation direction of the sunlight.

In another embodiment, the solar cell apparatus of the invention could include the control circuit except the light intensity-sensing device. The control circuit rotates the light-converging device for adjusting the light convergence direction according to a sun orientation database. Thus the light-converging device could obtain more energy from the sun all the time.

Additionally, the mechanism of rotating the light-converging device by the control circuit is the same as the mechanism of rotating the light-intensity device by the control circuit with two degrees of freedom. Because the control circuit and the light intensity-sensing device are used to sense the radiation direction of the solar energy for adjusting the light-converging device to obtain maximum solar energy, the application and description of the control circuit and the light intensity-sensing device is also applied to the previous scope.

In sum, the solar cell apparatus of the invention has a high efficient heat-dissipating structure, i.e. the above-mentioned heat-conducting device and heat-dissipating device. The heat-dissipating device includes a plurality of fins for enhancing dissipating and the heat-conducting device could include a heat pipe for conducting heat, generated in operation by the semiconductor structure of the energy-converting device, to the heat-dissipating device efficiently, which overcomes the problems of inefficiently dissipating heat in the prior art. Additionally, the solar cell apparatus of the invention includes a light-converging device that can converge the sunlight efficiently to raise the energy conversion power. Furthermore, the solar cell apparatus of the invention includes the light intensity-sensing device and the control circuit for sensing the radiation direction of the solar energy. Besides, the light convergence direction of the light-converging device is adjusted according the sensed radiation direction, so as to raise the intensity value of the light absorbed by the semiconductor structure. It is beneficial to raising the energy conversion power.

The objective of the present invention will no doubt become obvious to those of ordinary skill in the art after reading the following detailed description of the preferred embodiment, which is illustrated in the various figures and drawings.

### BRIEF DESCRIPTION OF THE APPENDED DRAWINGS

FIG. 1 illustrates a front view of a solar cell apparatus according to a preferred embodiment.
FIG. 2 illustrates a cross section of the solar cell apparatus in FIG. 1 along X-X line.
FIG. 3 illustrates a cross section of the solar cell apparatus in FIG. 2 along Y-Y line.
FIG. 4 illustrates a partially enlarged drawing of a light-converging device and an energy-converting device.
FIG. 5 illustrates a profile trace of a paraboloid of the cup-like reflection surface in FIG. 4.
FIG. 6 illustrates a partially enlarged drawing of a light-converging device and an energy-converting device according to another preferred embodiment.
FIG. 7 illustrates a partially enlarged drawing of a light-converging device and an energy-converting device according to an embodiment.
FIG. 8 illustrates a partially enlarged drawing of a light-converging device and an energy-converting device according to another embodiment.
FIG. 9 illustrates a partially enlarged drawing of a light-converging device and an energy-converting device according to another embodiment.
FIG. 10A illustrates an enlarged drawing of the energy-converting device and part of the heat-conducting device in FIG. 2.
FIG. 10B to FIG. 10F illustrate variants of the energy-converting device.
FIG. 11 illustrates a heat transfer path of the heat generated in operation by the semiconductor structure.
FIG. 12 illustrates a cross section of a solar cell apparatus according to an embodiment.
FIG. 13A illustrates a solar cell apparatus according to another preferred embodiment.
FIG. 13B illustrates a solar cell apparatus according to an embodiment.
FIG. 14 illustrates a solar cell apparatus according to a preferred embodiment.
FIG. 15 illustrates a function block diagram of the control circuit of the solar cell apparatus.
FIG. 16 illustrates an operation mechanism of the light-converging device of the solar cell apparatus.
FIG. 17 illustrates an operation mechanism of the light intensity-sensing device of the solar cell apparatus according to an embodiment.

### DETAILED DESCRIPTION OF THE INVENTION

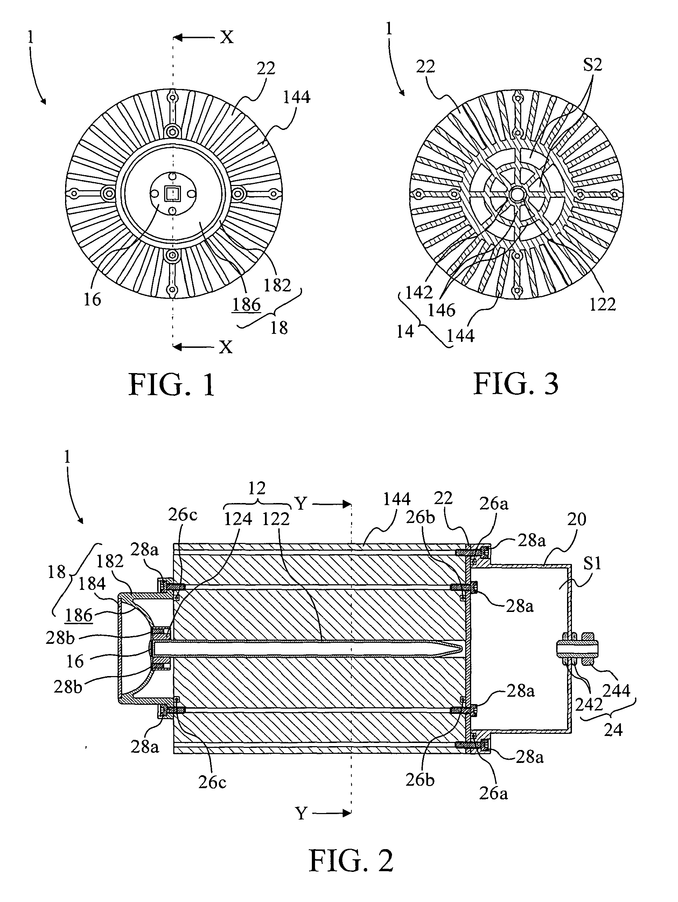

Please refer to FIG. 1, FIG. 2, and FIG. 3. FIG. 1 illustrates a front view of a solar cell apparatus 1 according to a preferred embodiment of the invention. FIG. 2 illustrates a cross section of the solar cell apparatus 1 in FIG. 1 along X-X line. FIG. 3 illustrates a cross section of the solar cell apparatus 1 in FIG. 2 along Y-Y line. According to the preferred embodiment, the solar cell apparatus 1 of the invention includes a heat-conducting device 12, a heat-dissipating device 14, an energy-converting device 16, a light-converging device 18, a back cover 20, a partition plate 22, a channel 24, several O rings 26a, 26b, 26c, and several screws 28a, 28b. The heat-dissipating device 14 includes a tubular body 142, a plurality of fins 144, and ribs 146 connecting the tubular body 142 and the fins 144. In order to express a geometric relation of the energy-converting device 16, a transparent partition plate 184 of the light-converging device 18 is not illustrated in FIG. 1.

Therein, the heat-conducting device 12 includes a heat pipe 122 and a supporting portion 124. The heat pipe 122 could be replaced by a heat column or other materials with high heat-conducting efficiency. In one embodiment, the heat pipe comprises a hollow body formed of copper and a capillary structure formed inside the hollow body, and the capillary structure exists on the contact portion of the heat pipe. In another embodiment, the capillary structure exists on both the contact portion and the flat portion of the heat pipe. The heat pipe 122 is inserted in the tubular body 142 of the heat-dissipating device 14. In other words, the heat pipe 122 contacts the heat-dissipating device 14 through its contact portion. In principle, except portions of the heat pipe 122 engaged with the supporting portion 124 and the energy-converting device 16, else portions of the heat pipe 122 could be regarded as the contact portion that the heat-dissipating device 14 could contact with alternatively.

The energy-converting device 16 is mounted on the supporting portion 124 by the screws 28b and contacts the heat pipe 122. The light-converging device 18 includes a housing 182, mounted on the heat-dissipating device 14 by the screw 28a, and a cup-like reflection surface 186 around the energy-converting device 16. In order to prevent the energy-converting device 16 from collision with other objects, the transparent partition plate 184 is disposed on the housing 182 and protects the energy-converting device 16 without reducing the amount of photo energy of the light transiting the partition plate 184 excessively. The back cover 20 is engaged to the heat-dissipating device 14 by the screw 28a and the partition plate 22 are disposed between them. The back cover 20 and the partition plate 22 form an accommodating space S1 to accommodate some circuits and electronic devices. The partition plate 22, the light-converging device 18, and the ribs 146 of the heat-dissipating device 14 form several accommodating spaces S2 for providing channels for the electrical connection between the above-mentioned circuits and the energy-converting device 16. The channel 24 is disposed on the back cover 20 for the above-mentioned circuit to be electrically connected to the outside. The channel 24 is mounted on the back cover 20 by two nuts 242 and has another nut 244 for external connection. Additionally, each accommodating space S1, S2 could be sealed by use of the O rings 26a, 26b and 26c and the channel 24 is waterproof for sealing.

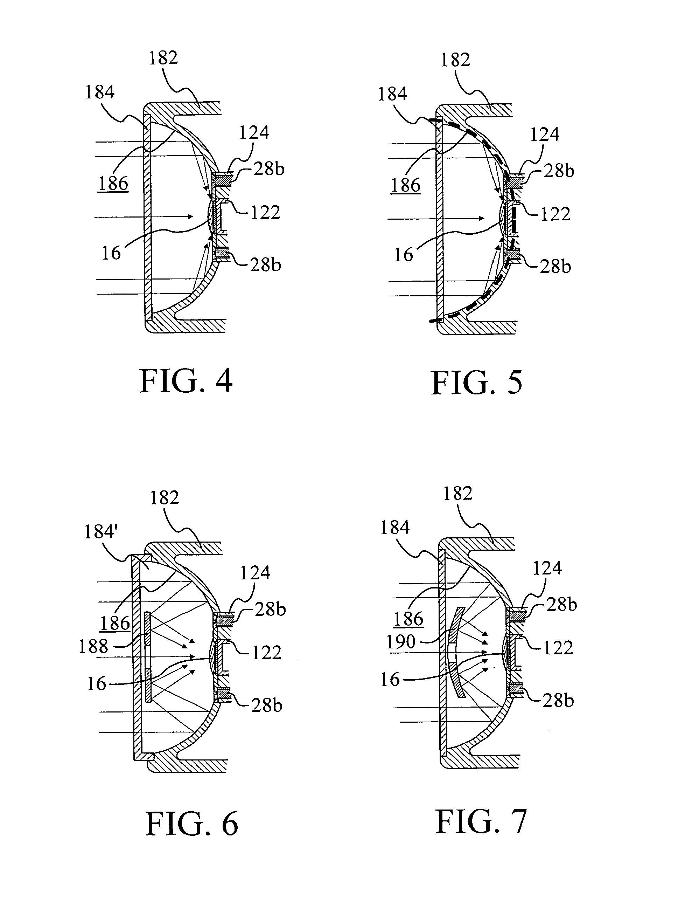

Please refer to FIG. 4. FIG. 4 illustrates a partially enlarged drawing of the light-converging device 18 and the energy-converting device 16. In FIG. 4, a line with an arrow represents an optical path (a traveling path of light). FIG. 4 illustrates that after light passes through the transparent partition plate 184, part of the light is reflected by the cup-like reflection surface 186 so that a traveling direction of the light changes. With a proper design of the curve surface of the cup-like reflection surface 186, the reflected light could travel toward the energy-converting device 16. Thus, the solar cell apparatus 1 of the invention could enlarge the area for converging light and the amount of absorbing solar energy will increase thereby.

In general, when the curve surface is a paraboloid, the reflection focus is inside of the paraboloid. Please refer to FIG. 5. FIG. 5 illustrates a profile trace of a paraboloid of the cup-like reflection surface 186 in FIG. 4, which is represented as a bold dotted line. The smaller the curvature is, the farther the focus is (far form the apex of parabolic curve). It also means that the structure as shown in FIG. 5 could not be applied directly; in other words, the opening of the cup-like reflection surface 186 of the structure could not expand for converging light onto the energy-converting 16. Therefore, the light-converging device 18 of the invention is provided with a design of second reflection so that the focus of the cup-like reflection surface 186 could reversely fall on the energy-converting 16 and the space for accommodating devices could be saved. The volume of the solar cell apparatus 1 of the invention is therefore not too large to practice. Please refer to FIG. 6. FIG. 6 illustrates a partially enlarged drawing of a light-converging device 18 and an energy-converting device 16 according to another preferred embodiment of the invention. The difference between the embodiments in FIG. 4 and FIG.6 is that the embodiment in FIG. 6 further includes a reflection plane 188 for reflecting the light reflected by the cup-like reflection surface 186, so that the light could be converged onto the energy-converting device 16.

As shown in FIG. 6, not all of reflection plane 188 is used. For example, the central part of the reflection plane 188 is not required because no light is reflected by the central part of the cup-like reflection surface 186 (where the light-converging device 18 is disposed). Therefore, the central part of the reflection plane 188 could be hollowed out or transparent for irradiating the light through the central part directly onto the energy-converting device 16. Additionally, in consideration of the reflection distance of the reflection plane 188 in FIG. 6, a transparent partition plate 184' is more protrusive than the transparent partition plate 184 shown in FIG. 4 for accommodating the reflection plane 188. Of course, the reflection plane 188 could be formed on the transparent partition plate 184' directly. For example, reflective material is coated on the surface of the transparent partition plate 184' where is toward the energy-converting device 16 and the light is reflected. So the transparent partition plate 184' needs not to be protrusive excessively.

Additionally, the reflection plane 188 in FIG. 6 could be replaced by a reflection curve surface 190 as shown in FIG. 7. FIG. 7 illustrates a partially enlarged drawing of a light-converging device 18 and an energy-converting device 16 according to an embodiment of the invention. The difference between the FIG. 6 and FIG. 7 is that in FIG. 7, the reflection curve surface 190 replaces the reflection plane 188. The light reflected by the cup-like reflection surface 186 could be further reflected and converged by the reflection curve surface 190 to irradiate onto the energy-converting device 16. By doing so, the distance from the reflection curve surface 190 to the energy-converting device 16 could be shortened. That is, the protrusive transparent partition plate 184' in FIG.6 is not required herein; the light is more concentrated on a work area of the energy-converting device 16. Of course, the reflection curve surface 190 could be integrated in the process of manufacturing the transparent partition plate 184 and the above-mentioned method of manufacturing the reflection plane 188 and the hollowing design of the reflection plane 188 are also applied to this embodiment.

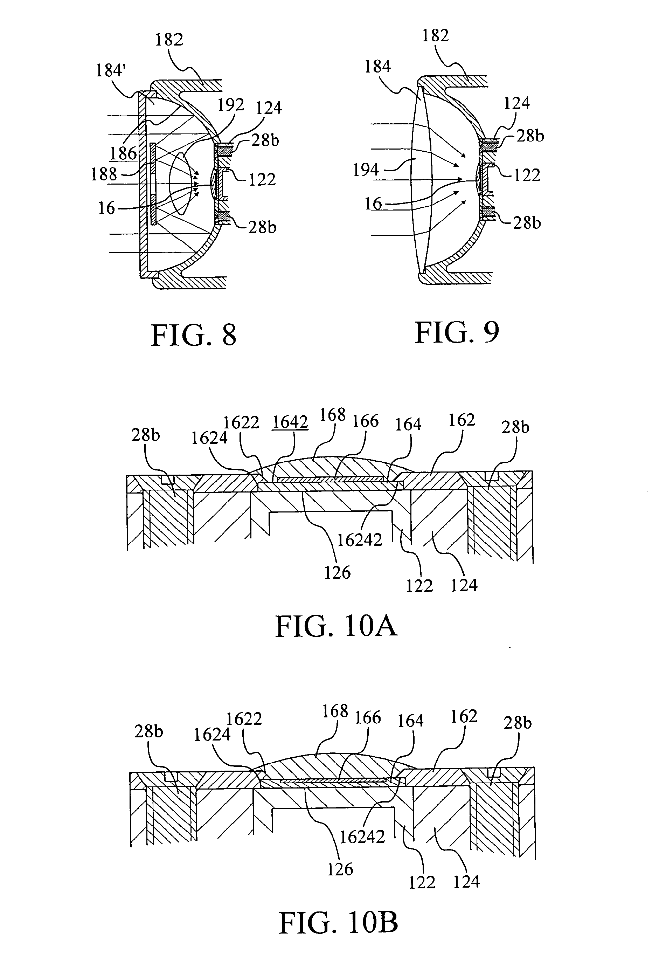

Please refer to FIG.8. FIG. 8 illustrates a partially enlarged drawing of a light-converging device 18 and an energy-converting device 16 according to another embodiment of the invention. The difference between FIG. 6 and FIG. 8 is that the reflected light is converged by a positive lens 192 to irradiate onto the energy-converting device 16 in FIG. 8. The lens 192 is shown in FIG. 8 without hatched lines in order to express the optical path clearly. Therefore, the lens 192 could shorten the distance. Similarly, the disposition of the lens 192 in FIG. 8 is also applied to the case shown in FIG. 7.

Please refer to FIG. 9. FIG. 9 illustrates a partially enlarged drawing of a light-converging device 18 and an energy-converting device 16 according to another embodiment of the invention. The difference among FIG. 9 and other embodiments is that the light-converging device 18 includes a positive lens 194 for converging the light onto the energy-converting device 16. The lens 192 is shown in FIG. 8 without hatched lines in order to express the optical path clearly. Therefore, the transparent partition plate 184, the cup-like reflection surface 186, the reflection plane 188, and the reflection curve surface 190 could be skipped. Of course, the cooperation use of these devices could also achieve the purpose of the invention.

Additionally, in above-mentioned embodiments, the curvature of the cup-like reflection surface 186, the reflection plane 188, and the reflection curve surface 190, and the optical path are just schematically drawn and do not represent the real sizes and the real paths. Moreover, the positive lens 192, 194 are not limited to be convexo-convex lenses and they could be lens assemblies that include a two-dimensional array of lenses.

Please refer to FIG. 10A. FIG. 10A illustrates an enlarged drawing of the energy-converting device 16 and part of the heat-conducting device 12 in FIG. 2. The energy-converting device 16 of the solar cell apparatus 1 of the invention includes a substrate 162, a base 164, and a semiconductor structure 166. The semiconductor structure 166 is for converting light into electricity. Therein, the semiconductor structure 166 could be a silicon-based semiconductor solar cell, a compound semiconductor solar cell, an organic semiconductor solar cell or other semiconductor structure capable of converting light into electricity; the substrate 162 is a silicon substrate, a ceramic substrate, a printed circuit board or a metal substrate. The base 164 could be a silicon base, a ceramic base, or a metal base. The substrate 162 includes a first recess 1622 and a second recess 1624 communicating with the first recess 1622, the base 164 is disposed on the second recess 1624 and include a surface 1642 toward the first recess 1622, and the semiconductor structure 166 is disposed on the surface 1642. The substrate 162 is mounted on the supporting portion 124 of the heat-conducting device 12 by the screws 28b and the base 164 contacts the flat portion 126 of the heat-conducting device 12. According to the preferred embodiment, the flat portion 126 is at an end of the heat pipe 122.

Additionally, an opening profile of the first recess 1622 is smaller than an opening profile of the second recess 1624, so that the second recess 1624 has a top portion 16242. The surface 1642 of the base 164 contacts the top portion 16242 so that the base 164 is disposed on the second recess 1624 firmly. Therein, the opening profiles of the first recess 1622 and the second recess 1624 are not limited to be circles and they could be rectangles. Additionally, the so-called "the opening profile of the first recess is smaller than the opening profile of the second recess 1624" does not only mean that the cross section formed by the opening profile of the second recess 1624 covers the cross section formed by the opening profile of the first recess 1622 completely but also means all situations that the second recess 1624 could form the top portion 16242 that the surface 1642 of the base 164 could contact with.

In the energy-converting device 16 in FIG. 10A, although the substrate 162 and the semiconductor structure 166 are packed by a packing material 168 simultaneously, the semiconductor structure 166 and the base 164 could be wire boned and packed together and then the base 164 is electrically connected to the substrate 162 through the top portion 16242 of the second recess 1624 for electrically connecting the semiconductor structure 166 and the substrate 162. Thus, the semiconductor structure 166 could be packed in advance. It is helpful for simplifying the packing environment, and raising the stability of packing and the yield rate. Although the base 164 electrically connected to the semiconductor 166 could be wire boned with the substrate 162 for electrical connection, that the base 164 directly electrically contacts the top portion 16242 of the second recess 1624 for electrical connection could increase the stability of electrical connection and prevent from being unstable resulting from wire bonding and packing.

Additionally, by use of the technology of integrating process to one embodiment (please refer to FIG. 10B), the base 164 could include the semiconductor structure 166. In other words, the base 164 is a semiconductor chip and the semiconductor chip includes the semiconductor structure 166 so that the heat-conducting efficiency increases. Therefore, the heat-dissipating device 14 could dissipate the heat generated in operation by the semi-conductor structure 166 more efficiently. Moreover, the integrated semiconductor structure 166 and the base 164 (or the semiconductor chip) could reduce the variations of the manufacturing of die bonding and increase the stability of manufacturing the whole energy-converting device 16. In FIG. 10B, the packing material 168 could be skipped or retained for protecting the semiconductor structure 166. By the way, the shape of the protrusive packing material 186 shown in FIG. 10B is helpful for converging the incident light onto the semiconductor structure 166.

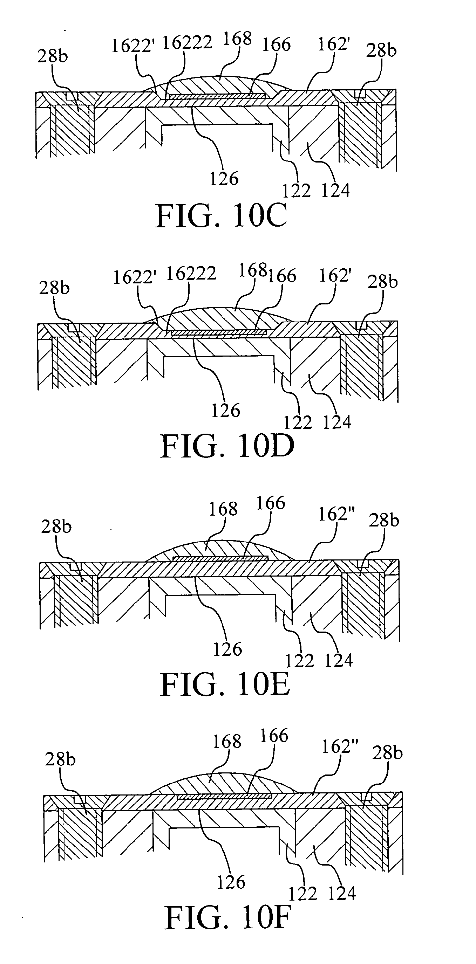

In another embodiment as shown in FIG. 10C, the energy-converting device 16 could include the substrate 162 and the semiconductor structure 166. The semiconductor structure 166 is disposed at the bottom 16222 of a recess 1622' of a substrate 162'. Of course, the semiconductor structure 166 could be similar to the structure shown in FIG. 10B or the semiconductor structure 166 is formed at the bottom 16222 directly as shown in FIG. 10D. The description of the packing material 168 in FIG 10B is also applied here. Additionally, the semiconductor structure 166 of the invention could be disposed on a substrate 162" without any recess as shown in FIG. 10E. Similarly, the semiconductor structure 166 could be formed on the substrate 162" directly as shown in FIG. 10F. Therein, the description of the packing material 168 in FIG. 10B is also applied here. Additionally, when the semiconductor structure 166 is formed on the single substrate 162' or 162' directly (as shown in FIG. 10D and FIG. 10F), the structure in FIG. 10A could be simplified so that the major devices of the energy-converting device 16 could be made in the process of manufacturing the semiconductor structure 166, which reduces the variations and improve the stability of manufacturing the energy-converting device 16.

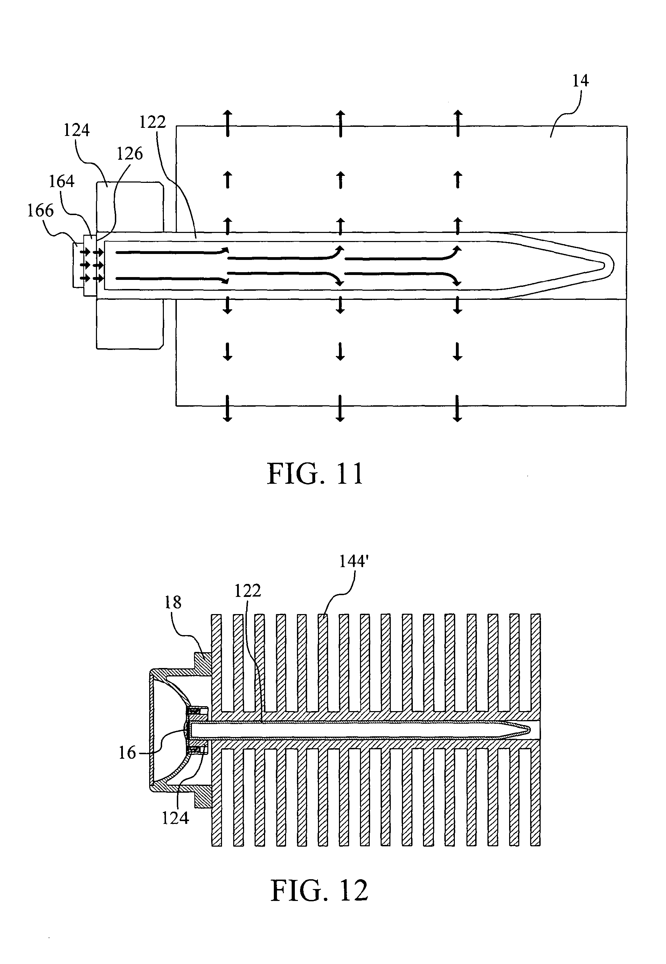

A heat transfer path about transferring the heat generated in operation by the semiconductor structure 166 is shown in FIG. 11. Additionally, in order to express the heat transfer path clearly, FIG. 11 is simplified and not to scale, and the hatched lines and dissociated notations are skipped. The heat generated in operation by the semiconductor structure 166 is conducted through the base 164 and then is transferred via the flat portion 126 to the heat pipe122. The wall of the heat pipe 122 near the flat portion 126 absorbs the heat transferred from the base 164. When a liquid (not shown in the figure) accommodated in the heat pipe 122 contacts the above-mentioned wall of the heat pipe 122, it absorbs the heat (the magnitude of the absorbed heat bigger than the vaporization heat of the liquid) to convert into gas (by the way of vaporization), and the gas form a thermal convection in the chamber of the heat pipe 12. When the hot gas contacts a relatively cool wall, the gas releases the vaporization heat to return to the liquid and the above cycle is repeated. The released vaporization heat and heat partially released by the liquid are absorbed by the wall which the gas contacts. When the external part of the wall is the heat-dissipating device 14 contacting the heat pipe 12, the heat stored in the wall is conducted to the heat-dissipating device 14. Most of the heat in the heat-dissipating device 14 is conducted to the fins 144 and then is dissipated from the fins 144 into the air by convection.

Because the heat generated in operation by the energy-converting device 16 could be rapidly dissipated by the heat-conducting device 12 with high heat-conducting efficiency, so that the energy-converting device 16 could operate at a proper temperature to improve the energy conversion efficiency will increase. Additionally, the heat-dissipating device 14 of the invention has a fin structure to accelerate the speed of dissipating heat to the air, so that the heat-conducting efficiency of the heat-conducting device 12 will maintain a proper value. According to the solar cell apparatus 1 of the preferred embodiment of the invention, the fins 144 extend along the axis of the heat pipe 122 and are arranged along the radial direction of the heat pipe 122 but not limited to this. Practically fins 144' of the heat-conducting dev ice 12 could extend along the radial of the heat pipe 122 and are arranged along the axial direction of the heat pipe 122 as shown in Fig. 12. Additionally, FIG. 12 is just a schematically drawn. The details may be different from the FIG. 2 and some major devices are notated for identifying.

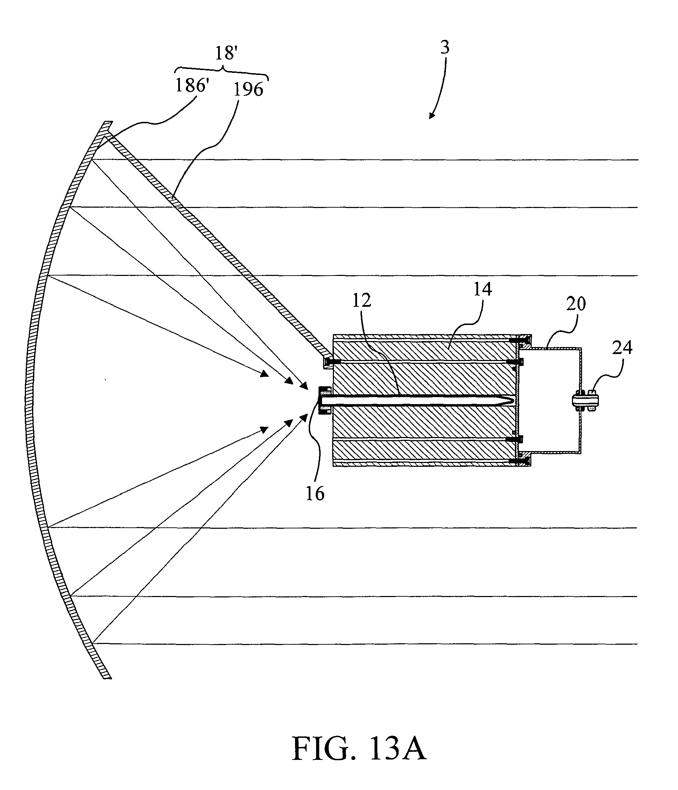

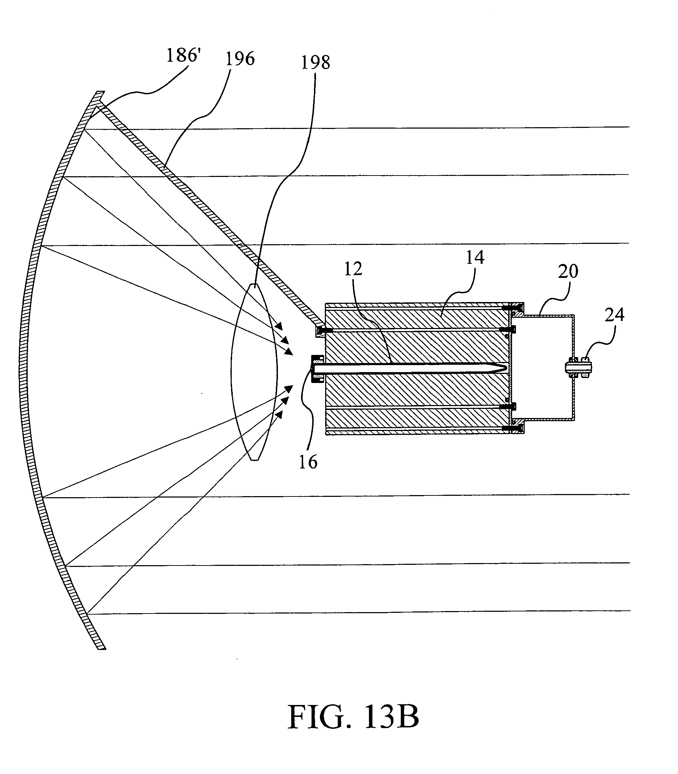

Please refer to FIG. 13A. FIG. 13A illustrate a solar cell apparatus 3 according to another embodiment of the invention. The difference between the solar cell apparatus 3 and the solar cell apparatus 1 shown in FIG. 2 is that a light-converging device 18' of the solar cell apparatus 3 is not disposed beside the energy-converting device 16 directly but opposite to the energy-converting device 16. As shown in FIG 13A, a cup-like reflection surface 186' of the light-converging device 18' faces the semiconductor structure 166 and is connected to and mounted on the heat-dissipating device 14 by a brace 196. Of course, the light-converging device 18' could be connected to the heat-dissipating device 14 by several braces 196 more firmly. A thin line with an arrow in FIG. 13A expresses an optical path. Comparing with the light-converging device 18 of the solar cell apparatus 1 in FIG. 2, the light-converging device 18' of the solar cell apparatus 3 could enlarge the area for collecting the light and then converging the light onto the semiconductor structure 166 of the energy-converting device 16. The structure shown in FIG. 13A occupies more space than the forementioned embodiments. In one embodiment, a positive lens 198 could be used for shortening the distance between the cup-like reflection surface 186' and the energy-converting device 16 for improving the space disposition. As shown in FIG. 13B, the positive lens 198 could be supported by the brace 196.

In the prior art, the heat generated by the structure shown in FIG. 13A will reduce the energy conversion efficiency, even bum the solar cell. In the invention, because the solar cell apparatus 3 of the invention has a heat-dissipating structure consisting of the heat-conducting device 12 with high heat-conducting efficiency and the heat-dissipating device 14, the semiconductor structure 166 could operate at a proper working temperature for high energy conversion power. Additionally, in the structure shown in FIG. 13A, the light-converging device 18' is regarded as a main supporting structure of the whole apparatus in principle. Because the structure is not the key point of the above explanation, it is not illustrated in FIG. 13 A. In application, a necessary design of the supporting structure should be made.

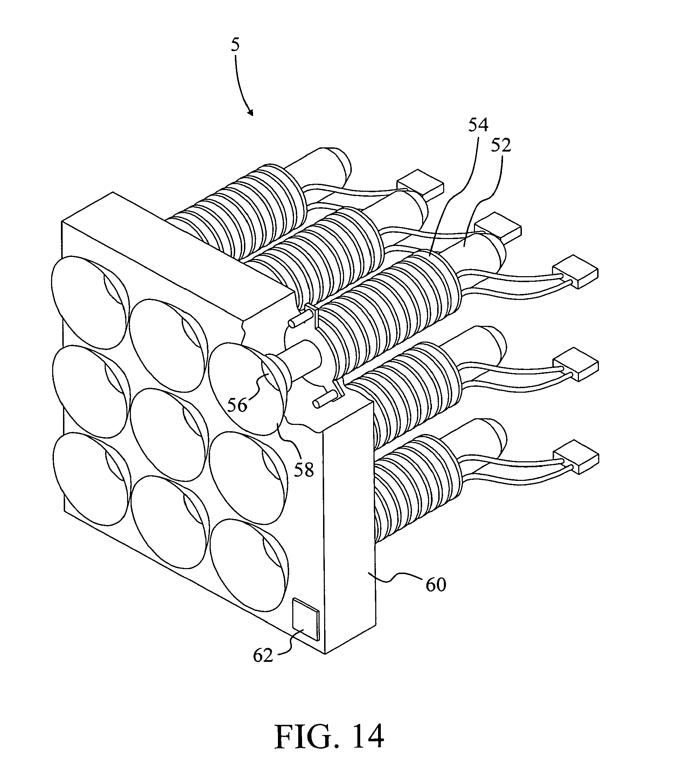

The invention also discloses an integrated solar cell apparatus and the solar cell apparatus 1 is regarded as a unit of the integrated solar cell apparatus. Several units are combined together for providing higher energy conversion power. Please refer to FIG. 14. FIG. 14 illustrates a solar cell apparatus 5 according to a preferred embodiment. The solar cell apparatus 5 of the invention includes a plurality of heat-conducting devices 52, a plurality of heat-dissipating devices 54, a plurality of energy-converting devices 56, and a supporting member 60. Unless any description is expressed specifically, the descriptions of the devices are similar to the forementioned descriptions and are no longer described here. Each heat-dissipating device 54 includes a plurality of circle fins and each heat-dissipating device 54 is mounted on the supporting member 60. Each of the heat-conducting devices 52 passes through the supporting member 60, so that each of the light-converging devices 58 corresponding to the corresponding energy-converting device 56 is exposed out of the supporting member 60.

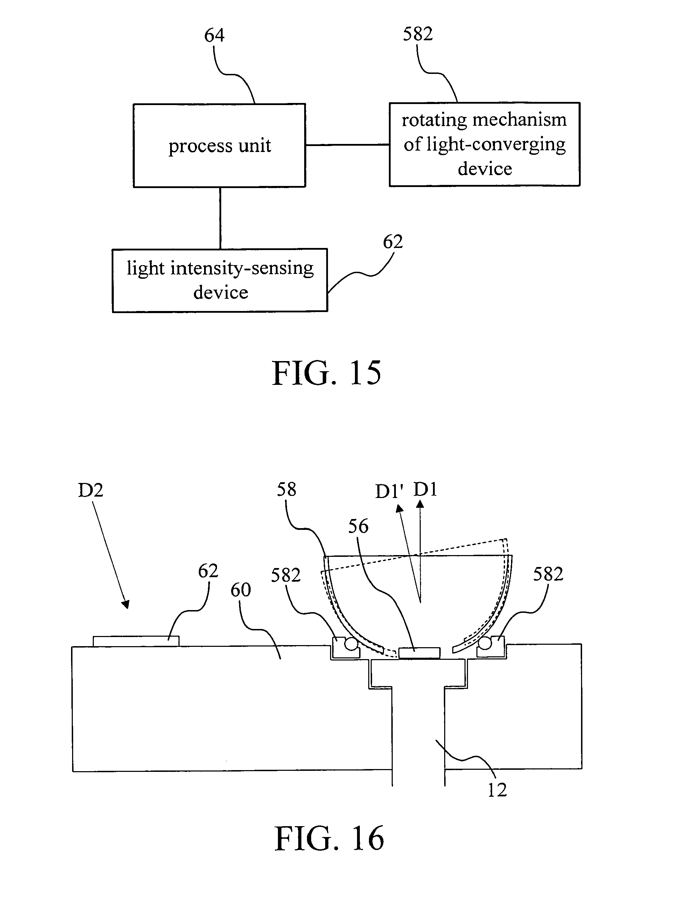

Moreover, the solar cell apparatus 5 of the invention further includes a light intensity-sensing device 62 and a control circuit. The control circuit mainly consists of a process unit 64 and circuits connected to the light intensity-sensing device 62 and the light-converging device. A function block diagram of the control circuit is shown in FIG. 15. The light intensity-sensing device 62 could sense the light intensity and the process unit 64 retrieves the light intensity and rotates a rotating device 582 of the light-converging device 58 according to the light intensity to control a light convergence direction D1 of the light-converging device 58. Please refer to FIG. 16 to understand its operation mechanism. FIG. 16 only illustrates the relative schematic blocks and dotted lines in FIG. 16 represent the result of controlling the light-converging device 58 by the process unit 64. As shown in FIG. 16, the light intensity-sensing device 62 senses the radiation direction D2 of solar energy and the process unit 64 controls the rotating device 582 of the light-converging device 58 to rotate according to the radiation direction D2 of solar energy. By doing so, the light convergence direction D1 of the light-converging device 58 rotates toward to a new light convergence D1' and the new light convergence D1' is parallel to the radiation direction D2 of solar energy substantially. Thus, more solar energy could be converged by the light-converging device 58.

Additionally, the forementioned light intensity is not limited to a single value and it could be a parameter. Take FIG. 16 for example. The light intensity could be a direction parameter and it could further include an intensity value. The radiation direction D2 of solar energy could be determined according to the direction parameter. In logic, it could represent the radiation direction D2 of solar energy. The intensity value is the magnitude of solar energy sensed by the light intensity-sensing device 62. The sensing of the radiation direction D2 of solar energy could be performed by disposing three different directional light-sensing chips disposed on the light intensity-sensing device 62, retrieving the sensed values from the three different directional light-sensing chips respectively by the process unit 64 and then establishing a vector relation according the corresponding sensing direction to determine the radiation direction D2 of solar energy.

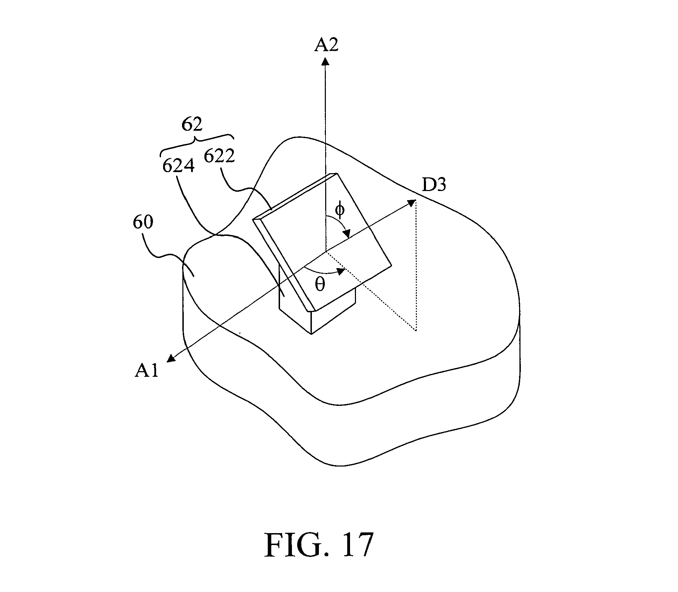

Please refer to FIG. 17 to understand another approach for sensing the radiation direction D2 of solar energy by use of a signal light-sensing chip. FIG. 17 only illustrates schematic blocks of the relative devices. The light intensity-sensing device 62 includes a light-sensing chip 622 and a rotating device 624. The normal direction of the light-sensing chip 622 is defined as D3. A1 is defined as a horizontal reference direction; A2 is defined as a vertical reference direction; θ is defined as a horizontal direction angle that is an angle between the projected angle of the normal direction D3 onto a horizontal plane and the horizontal reference direction A1; φ is defined as an angle of elevation that is an angle between the normal direction D3 and the vertical reference direction A2. The rotating device 644 makes the light-sensing chip 622 rotate relative to the vertical reference direction A2; that is, there is a motive degree of freedom at the horizontal directional angle. The rotating device 624 rotates the light-sensing chip 622 diverging form the vertical reference direction A2. It also means there is a motive degree of freedom at the angle of elevation φ. Therefore, the rotating device 624 could rotate the light-sensing chip 622 with two degrees of freedom; that is, the process unit 64 of the control circuit could control the rotating device 624 to rotate the light intensity-sensing device 62 with two degrees of freedom. By doing so, the light intensity-sensing device 62 could sense the values of intensity with different directions and transmit light intensity parameters consisting of the values, the horizontal directional angles θ, and the angles of elevation φ to the process unit 64 for calculating.

In general, the radiation direction of solar energy could be determined by three groups of light intensity parameters. If an accurate calculation is needed, the current determined radiation direction of solar energy could be a reference for of determining the next radiation direction of solar energy. Another three groups of light intensity parameters are sensed and then to calculate the next radiation direction of solar energy, which is performed repeatedly until the difference between the current radiation direction and the previous one is allowable. Although it may spend more time, it is practicable due to the times of rotating light-converging device 58 not huge. Additionally, due to sun azimuth changing slightly everyday, if a sun orientation database is established, the solar cell apparatus 5 of the invention could control the light-converging device 58 directly rather than sensing the radiation direction of solar energy by the light intensity-sensing device 62. Although the light convergence direction D1 is adjusted for obtaining the maximum solar energy, the invention is not limited to this. For example, if the temperature of some energy-converting device 56 is too high to operate, the light convergence direction D1 of the corresponding light-converging device 58 could be adjusted for preventing the energy-converting device 56 from burning. In view of this, the solar cell apparatus 5 of the invention could protect the energy-converting device 56.

Additionally, the descriptions in FIG.1 to FIG. 13B about the light-converging device, the reflection, the convergence of the light by a lens, the optical path and the disposition of the devices and the variants thereof are also applied to the solar cell apparatus 5 in FIG. 14. It will no longer be explained it again. Similarly, in the solar cell apparatus 5, the description of the rotatable light-converging device 58 and the devices interacting therewith (for example, the light intensity-sensing device 62) are also applied to the solar cell apparatus 1, 3. It will no longer be explained it again.

In sum, the solar cell apparatus of the invention has a high efficient heat-dissipating structure for dissipating heat generated in operation by the semiconductor of the energy-converting device efficiently, so as to overcome the problems of inefficiently heat-dissipating in the prior art. Additionally, the solar cell apparatus of the invention includes a light-converging device for converging sunlight efficiently and raising the energy conversion power. Furthermore, the solar cell apparatus of the invention includes the light intensity-sensing device and the control circuit for sensing the radiation direction of the solar energy. It could adjust the light convergence direction of the light-converging device according to the radiation direction of the solar energy, so as to raise the intensity of solar energy that is absorbed by the semiconductor structure. It is helpful for raising the energy conversion power of the semiconductor structure. Thus, the solar cell apparatus of the invention could raise the energy conversion efficiency and power efficiently, so as to be applied to electronic products depleting high power or the operation of storing electricity.

Although the present invention has been illustrated and described with reference to the preferred embodiment thereof, it should be understood that it is in no way limited to the details of such embodiment but is capable of numerous modifications within the scope of the appended claims.

## Claims

1. A solar cell apparatus comprising:
a heat-conducting device comprising a flat portion and a contact portion;
a heat-dissipating device contacting the contact portion of the heat-conducting device; and
an energy-converting device disposed on the flat portion of the heat-conducting device and comprising a semiconductor structure for converting light into electricity.

2. The solar cell apparatus of claim 1, wherein the heat-dissipating device comprises a plurality of fins.

3. The solar cell apparatus of claim 1, further comprising a light-converging device disposed near the energy-converting device for converging the light onto the semiconductor structure.

4. The solar cell apparatus of claim 3, wherein the light-converging device comprises a cup-like reflection surface for reflecting and converging the light to irradiate onto the semiconductor structure.

5. The solar cell apparatus of claim 4, wherein the light-converging device comprises a reflection plane or a reflection curve surface for reflecting the light reflected by the cup-like reflection surface onto the semiconductor structure.

6. The solar cell apparatus of claim 5, wherein the light-converging device comprises a positive lens for converging the light reflected by the reflection plane or the reflection curve surface onto the semiconductor structure.

7. The solar cell apparatus of claim 3, wherein the light-converging device comprises a positive lens for converging the light onto the semiconductor structure.

8. The solar cell apparatus of claim 1, wherein the semiconductor structure is a silicon-based semiconductor solar cell, a compound semiconductor solar cell, or an organic semiconductor solar cell.

9. The solar cell apparatus of claim 1, wherein the heat-conducting device comprises a heat pipe or a heat column.

10. The solar cell apparatus of claim 9, wherein the flat portion is at an end of the heat pipe or the heat column.

11. The solar cell apparatus of claim 1, wherein the energy-converting device comprise a substrate and a semiconductor chip, the substrate comprises a first recess and a second recess communicating with the first recess, and the semiconductor chip is disposed on the second recess, comprises the semiconductor structure, and contacts the flat portion of the heat-conducting device.

12. The solar cell apparatus of claim 1, wherein the energy-converting device comprises a substrate and a base, the substrate comprises a first recess and a second recess communicating with the first recess, the base is disposed on the second recess and comprises a surface toward to the first recess, the semiconductor structure is disposed on the surface, and the base contacts the flat portion of the heat-conducting device.

13. The solar cell apparatus of claim 12, wherein an opening profile of the first recess is smaller than an opening profile of the second recess, so that the second recess has a top portion which contacts the surface of the base.

14. The solar cell apparatus of claim 13, wherein the base is electrically connected to the substrate through the top portion of the second recess.

15. The solar cell apparatus of claim 12, wherein the heat-conducting device comprises a supporting portion and the substrate is mounted on the supporting portion.

16. The solar cell apparatus of claim 12, wherein the substrate is a silicon substrate, a ceramic substrate, a printed circuit board or a metal substrate.

17. The solar cell apparatus of claim 12, wherein the base is a silicon base, a ceramic base, a printed circuit board or a metal base.

18. The solar cell apparatus of claim 12, wherein the semiconductor structure is formed on the base.

19. The solar cell apparatus of claim 1, wherein the energy-converting device comprises a substrate, the semiconductor structure is disposed on the substrate, and the substrate contacts the flat portion of the heat-conducting device.

20. The solar cell apparatus of claim 19, wherein the substrate of the energy-converting device comprises a recess and the semiconductor structure is disposed on the recess.

21. The solar cell apparatus of claim 19, wherein the substrate is a silicon substrate, a ceramic substrate, a printed circuit board or a metal substrate.

22. The solar cell apparatus of claim 19, wherein the semiconductor structure is formed on the substrate.

23. A solar cell apparatus comprising:
a plurality of heat-conducting devices, each of the heat-conducting devices comprising a flat portion and a contact portion;
a plurality of the heat-dissipating devices, each of the heat dissipating devices correspondingly contacting the contact portion of one of the heat-conducting devices;
a plurality of energy-converting devices, each of the energy-converting devices correspondingly being disposed on the flat portion of one of the heat-conducting devices, each of the energy-converting devices comprising a semiconductor structure for converting light into electricity; and
a supporting member connected to the heat-conducting devices or the heat-dissipating devices.

24. The solar cell apparatus of claim 23, wherein each of the heat-dissipating devices comprises a plurality of fins.

25. The solar cell apparatus of claim 23, further comprising a plurality of light-converging devices, each of the light-converging devices correspondingly being disposed near one of the energy-converting device for converging the light on the semiconductor structure of the corresponding energy-converting device.

26. The solar cell apparatus of claim 25, further comprising a light intensity-sensing device and a control circuit, wherein the light-converging device thereon defines a light convergence direction, the light intensity-sensing device senses a light intensity, and the control circuit rotates the light-converging device for adjusting the light convergence direction according to the light intensity.

27. The solar cell apparatus of claim 26, wherein the light intensity-sensing device comprises a rotating device and the control circuit controls the rotating device to rotate the light intensity-sensing device with two degrees of freedom.

28. The solar cell apparatus of claim 25, further comprising a control circuit, wherein the light-converging device thereon defines a light convergence direction, and the control circuit rotates the light-converging device for adjusting the light convergence direction according to a sun orientation database.

29. The solar cell apparatus of claim 25, wherein the light-converging device comprises a cup-like reflection surface for reflecting and converging the light to irradiate onto the semiconductor structure.

30. The solar cell apparatus of claim 29, wherein the light-converging device comprises a reflection plane or a reflection curve surface for reflecting the light reflected by the cup-like reflection surface onto the semiconductor structure.

31. The solar cell apparatus of claim 30, wherein the light-converging device comprises a positive lens for converging the light reflected by the reflection plane or the reflection curve surface onto the semiconductor structure.

32. The solar cell apparatus of claim 25, wherein the light-converging device comprises a positive lens for converging the light onto the semiconductor structure.
